# EUROPEAN PATENT APPLICATION

(11) **EP 4 024 003 A1**
(43) Date of publication of application: **06.07.2022**
(21) Application number: 21150331.3
(22) Date of filing: 05.01.2021
(51) Int. Cl.: G01B 1/00, G01B 21/02, G01B 21/20, G01B 21/30, G01N 1/28, H01L 21/48, H01L 23/15, H01L 23/498

(54) **METHOD FOR NON-DESTRUCTIVE INSPECTION OF A STRUCTURE AND CORRESPONDING SYSTEM**

(71) Applicant: SCHOTT AG, 55122 Mainz (DE)
(72) Inventor: Corvers, Stephan, 65375 Oestrich-Winkel (DE); Loho, Christoph, 64295 Darmstadt (DE); Korb, Thomas, 55288 Partenheim (DE)
(74) Representative: Ullrich & Naumann PartG mbB

(57) **Abstract**

The present invention relates to a method for non-destructive inspection of a structure, preferably a through-glass via, TGV, of a substrate, preferably a glass substrate,
comprising the steps of
- Applying a mouldable mass onto a surface of said structure of said substrate,
- Hardening of said mouldable mass such that the mass is elastic,
- Non-destructive removing of said elastic mass from said structure, and
- Analyzing said removed elastic mass according to at least one parameter, preferably a quality parameter.

## Description

The present invention relates to a method for non-destructive inspection of a structure, preferably a through-glass via, TGV, of a substrate, preferably a glass substrate.

The present invention further relates to a system for non-destructive inspection of a structure, preferably a through-glass via, TGV, of a substrate, preferably a glass substrate.

The present invention even further relates to a method for manufacturing a structure preferably a through-glass via, TGV, of a substrate, preferably a glass substrate.

The present invention even further relates to a substrate, preferably a glass substrate, comprising a structure, preferably a through-glass via, TGV.

Although applicable to any kind of substrate, the present invention will be described in the context of a substrate in form of a glass substrate.

Although applicable to any kind of structure, the present invention will be described in the context of a structure in form of a through glass via - TGV.

In the semiconductor industry, through-glass vias - TGV - help to further miniaturize semiconductor devices. The ability to evaluate the quality of TGVs in substrates for the semiconductor industry is important for high volume manufacturing of structured glass for the semiconductor industry. To ensure quality of TGVs, some of the manufactured glass substrates have been examined using destructive testing, as shown for example in KR 20130065210 A. The glass substrate is cut to obtain a cross-section, in which the surface roughness is evaluated through optical or electron microscopy.

Another conventional method is to perform complex optical measurements of the TGVs that require mechanical displacement of the substrate as shown for example in US 10,531,566 B2. US 10,531,566 B2 discloses a method of quality control of TGVs in glass based on optical microscopy. Each individual TGV is analyzed two dimensionally from the top and bottom opening of the via, and an indirect measurement of the perpendicularity is obtained. This measurement does not allow for determination of the properties of the inner surface of the TGV, such as roughness, which is important to optimal metallization and signal propagation.

Embodiments of the present invention therefore address the problem of providing a method for inspecting a structure on or in a substrate, which is easy to implement, provides a high accuracy when determining quality parameters of the structure and enables non-destructive inspection of a structure.

In an embodiment, the present invention provides a method for non-destructive inspection of a structure, preferably a through-glass via, TGV, of a substrate, preferably a glass substrate,
comprising the steps of
- Applying a mouldable mass onto a surface of said structure of said substrate,
- Hardening of said mouldable mass such that the mass is elastic,
- Non-destructive removing of said elastic mass from said structure, and
- Analyzing said removed elastic mass according to at least one parameter, preferably a quality parameter.

In a further embodiment, the present invention provides a system for non-destructive inspection of a structure, preferably a through-glass via, TGV, of a substrate, preferably a glass substrate, comprising
an applying entity adapted for applying a mouldable mass onto a surface of said structure of said substrate,
a hardening entity adapted for hardening of said mouldable mass, such that the mass is elastic,
a removing entity adapted for non-destructive removing of said elastic mass from said structure, and
an analyzing entity adapted for analyzing said removed elastic mass according to at least one parameter, preferably a quality parameter.

In a further embodiment, the present invention provides a method for manufacturing a structure preferably a through-glass via, TGV, of a substrate, preferably a glass substrate, comprising the steps of:
- Providing a substrate,
- Forming a structure in and/or on said substrate,
- Inspecting said structure by performing a method according to one of the claims 1-10.

In an even further embodiment, the present invention provides a substrate, preferably a glass substrate, comprising a structure, preferably a through-glass via, TGV, provided by a method according to one of the claims 13-14.

In other words, the present invention provides inter alia a non-destructive method and a corresponding system using a mouldable mass hardened to an elastic mass as a proxy for the structured substrate, preferably comprising glass. The mouldable mass hardened later to an elastic mass is shaped with great accuracy in or on the structures of the substrate and removed without damaging a costly structured substrate. The elastic mass' surface is then examined to determine one or more selected key performance indicators, such as surface roughness, geometry of the structure, preferably a via like circularity, diameter throughout the via, depression depth, taper angle, waist size, perpendicularity, deviation from cylindrical geometry, etc. In addition, although the elastic mass may also leave a residue that is undesirable for further processing of the structure, e.g. metallization, it may be easily removed through cleaning processes, e.g. known in the semiconductor industry.

The term "non-destructive removing" with regard to the term "elastic mass" is to be understood in its broadest sense and refers preferably in the description, in particular in the claims to a method, which enables relocating, removing, detaching, disconnecting, dislodging or the like of the elastic mass from the structure, such that neither the structure nor the elastic mass is damaged, modified or amended. The structure is in particular not damaged, modified or amended in such a way that further processing of the structure is affected. In particular, that means that the relevant properties, features, quality or characteristics of the structure, the substrate and the elastic mass are not amended, changed or modified due to relocating, removing, detaching, disconnecting or dislodging.

For instance conventional quality assurance measurements for TGVs in a glass substrate such as surface roughness and geometry require a cross-section to be cut through the glass article, thereby destroying it and reducing overall product yield. A non-destructive method according to embodiments of the present invention using an elastic mass improves yield thereby avoiding this deficiency. Furthermore, a cross-section enables only a limited number of structures to be evaluated, whereas the elastic mass according to embodiments of the present invention allows a significantly larger number of structures to be evaluated. Another disadvantage of cross-section measurements is that the TGV is not perfectly cut across, limiting the ability to evaluate the geometry.

One of the advantages, which may be accomplished by embodiments of the present invention is an easy implementation. One of the further advantages, which may be accomplished by embodiments of the present invention is a non-destructive measurement of properties or characteristics of structures in and/or on a substrate. One of the advantages, which may be accomplished by embodiments of the present invention is a flexibility in terms of quality parameters describing the properties of the structure of the substrate.

One of the further advantages, which may be accomplished by embodiments of the present invention is that microstructures, for instance through glass vias having a diameter of less than 500 micrometers, preferably less than 250 micrometers, preferably 100 micrometers or even lower up to 5 micrometers, can be easily and reliably non-destructively inspected.

Further features, advantages and further embodiments are disclosed or may become apparent in the following:
According to an embodiment of the invention said hardening is performed by applying at least one of
- chemical hardening, preferably by adding additional chemical additives,
- electromagnetic radiation, preferably IR-radiation and/or UV-radiation,
- solidification and/or conglomeration from a solution by volatilization of a solvent,
- cooling and/or heating.

One of the advantages may be that flexibility is enhanced since a variety of different hardening methods can be used depending on the mouldable mass composition. For instance, multi-component-systems can be used, which may provide a polyaddition reaction and/or a condensation reaction hardening the multi-component systems. Further, chemical hardening can include a polymerization of one or more monomers to a polymer by at least one of
- step-growth polymerization, where pairs of reactants combine in steps to the polymer, for instance polysiloxane, polyether, polyurethane or the like,
- chain-growth polymerization, where monomers are added to a growing chain with an active center forming the polymer. The active center needs to be formed once, for instance ethylen polymerizes by adding a catalyst - a common catalyst is titanium (III) chloride as an example for a so-called Ziegler-Natta catalyst.
- photopolymerization, where most of these types of reactions are chain-growth polymerization methods being initiated by absorption of visible or UV light.

Chemical hardening includes but is not limited to curing. Curing is a chemical process that produces the toughening or hardening of a polymer material by chain-growing and/or cross-linking, initiated by heat, radiation, electron beams and/or chemical additives. The chemical additives include also environmental substances like water provided as air humidity or the like. For instance, materials of a variety of different properties such as hardness, elasticity, durability can be obtained by heating of natural rubber with sulfur. Other methods provide polymerization to obtain thermoplastics or elastomers: Polymers in the form of thermoplastics can be obtained from a drying solution; thermoplastic elastomers can be obtained by liquefaction by applying heat.

According to an embodiment of the present invention, said hardening is performed within less than 1 hour, preferably less than 15 minutes, preferably less than 10 minutes, preferably less than 5 minutes. One of the advantages may be that a fast and efficient inspecting method can be achieved.

According to an embodiment of the present invention said elastic mass has a shore hardness below 70 A, preferably between 25 A and 65 A, preferably between 50 A and 60 A, after removal of said elastic mass from said surface. For instance the shore hardness may vary over time, in particular increasing within 24 hours after removal up to 20%: Shore hardness of a removed elastic mass after 10 minutes may be 47 A, after one hour 48 A and after 24 hours 51 A. The values of the shore hardness specified here may all allow realizing a detailed inspection and a non-destructive removal of the elastic mass. In another example, a quick hardening can be obtained for a mouldable mass with an application time of about 1.5-2 minutes and a hardening time of about 2 to 3 minutes. Preferably, the shore hardness is then determined at least within a time window of 5 to 15 minutes after removing the elastic mass from the structure. This may provide the advantage of a detailed inspection and a non-destructive removal of the elastic mass. Parameters include but are not limited to shore hardness, tensile strength, yield strength, elastic modulus, and elasticity. The parameters can be obtained for example based on DIN 65378, ISO 527-1 and/or according to Microtensile ASTM D1708 in the respective current version valid at December 1, 2020.

According to an embodiment of the present invention said structure of said substrate is provided in form of at least one of a groove, a cavity, a trench, a channel, an indentation, preferably in form of a scratch, a via, a blind hole, an edge, a rim, a pillar. This may provide the advantage of an enhanced flexibility of inspecting a large variety of different shaped structures.

According to an embodiment of the present invention said elastic mass is provided having a mould precision below 1 micrometer, preferably below 0.5 micrometer, preferably below 0.1 micrometer. This may provide the advantage of inspecting small structures and their surfaces in particular of structures used in semiconductor industry.

According to an embodiment of the present invention said mouldable mass is provided in form of at least one of a thermoplastic, an elastomer, preferably silicone, rubber, resin and/or epoxy, an adhesive. This may provide the advantage of an easy adaption to the form or shape of the surface of the structure as well as of the material of the substrate enabling a precise inspection.

According to an embodiment of the present invention said at least one parameter represents a surface roughness of said structure and/or a geometry of said structure. This may provide the advantage of providing relevant information about the structure for further processing.

According to an embodiment of the present invention, said parameter representing geometry specifies at least one of surface area, volume, height, length, width, circularity, diameter, depression depth, taper angle, hour glass angle, waist size, perpendicularity, and/or deviation from a theoretical structure. This may provide the advantage of providing detailed information about the structure for further processing.

According to an embodiment of the present invention, said parameter representing geometry is determined using light microscopy and/or wherein said parameter representing surface roughness is determined using light interference spectroscopy. This may provide the advantage of an easy and reliable determination of the relevant parameters.

According to an embodiment of the present invention, said at least one parameter is determined using light microscopy and/or interference spectroscopy, computer tomography, electron microscopy and/or fluorescence spectroscopy. This may provide the advantage of an easy and reliable determination of the relevant parameters.

According to an embodiment of the system, said analyzing entity comprises at least one of a microscopy entity, preferably a light microscopy entity and/or an electron microscopy entity, a spectrometer entity, preferably an interference and/or fluorescence spectrometer entity, a tomography entity, preferably a computer tomography entity and/or a magnetic resonance imaging entity. This may provide the advantage of a precise and reliable determination of parameters in particular based on the surface structure or texture of the removed elastic mass.

According to an embodiment of the system said system further comprising at least one of
- a holding entity adapted for holding a substrate, said substrate comprising at least one structure,
- a feeder entity adapted to feed said substrate to at least one other entity,
- a supplying entity adapted to supply said mouldable mass to said applying entity,
- a display entity adapted to display at least one of
   ∘ a 2D and/or 3D image of said elastic mass,
   ∘ a result of said analysis, or
   ∘ a 2D and/or 3D image of said structure.

This may provide the advantage of an easy handling and processing for inspection of the structure.

According to an embodiment of the method for manufacturing prior to inspecting said structure and/or after removing of said elastic mass from said structure, said surface of said structure is cleaned by applying one or more cleaning procedures, preferably comprising at least one of one or more intense alkaline cleaners, one or more acidic cleaners, one or more neutral cleaners, one or more rinsing fluids, preferably carried out in one or more tempered ultrasonic and/or megasonic bathes. Multiple cleaning procedures can be applied subsequently using different bathes and using different times within said bathes, wherein between said bathes a rinsing can be applied - interim rinsing. This may provide the advantage of ease of further processing by avoiding processing errors due to potential pollution by remnants of the elastic mass. The term "ultrasonic" refers here to frequencies reaching from 20 kHz to 400 kHz. The term "megasonic" refers here to frequencies reaching from 400 kHz to 2 MHz. In particular, megasonic cleaning can be used to remove particles having size below the micrometer regime.

According to an embodiment of the method for manufacturing prior to performing a cleaning procedure, the surface to be cleaned is measured in order to obtain a pollution indication parameter of said surface, and when said pollution indication parameter exceeds a threshold, the cleaning procedure is performed. This may provide the advantage of more efficient manufacturing, since for instance cleaning procedures are only performed when a certain level of pollution of the structure is determined.

There are several ways to design and further develop the teachings of the present invention in an advantageous way. To this end, it is to be referred to the patent claims subordinate to the independent patent claims on the one hand and to the following explanation of preferred examples of embodiments of the invention, illustrated by the drawing on the other hand. In connection with the explanation of the preferred embodiments of the invention by the aid of the drawing, generally preferred embodiments and further developments of the teaching will be explained.

In the drawings
- Fig. 1: shows a microscope image of a microsection of a TGV of a substrate according to an embodiment of the present invention;
- Fig. 2: shows a microscope image of an elastic mass removed from a TGV of the substrate of Fig. 1;
- Fig. 3: shows a microscope image of a microsection of a TGV of a substrate according to an embodiment of the present invention;
- Fig. 4: shows a microscope image of an elastic mass removed from a TGV of the substrate of Fig. 3;
- Fig. 5: shows steps of a method for non-destructive inspection of a structure, of a substrate according to an embodiment of the present invention;
- Fig. 6: shows schematically a system for non-destructive inspection of a structure, of a substrate according to an embodiment of the present invention; and
- Fig. 7: shows steps of a method for manufacturing of a structure of a substrate according to an embodiment of the present invention.

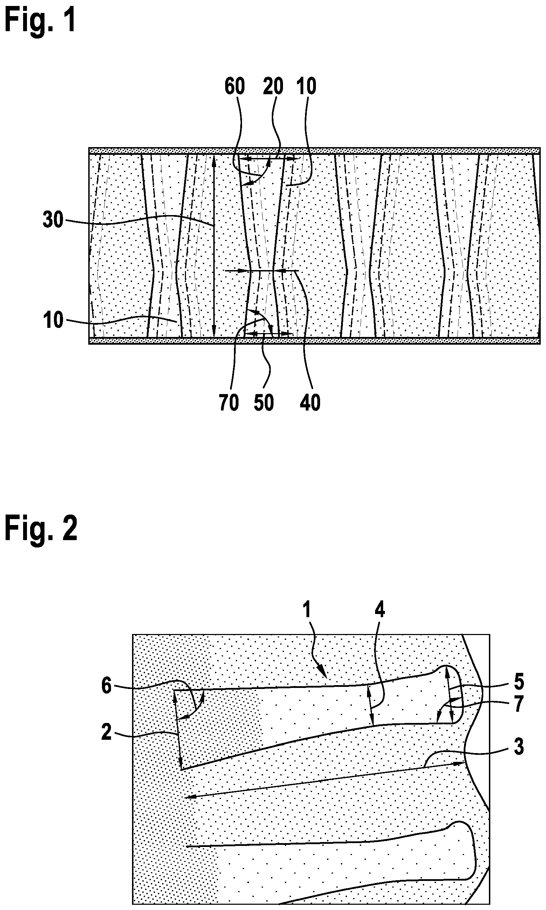

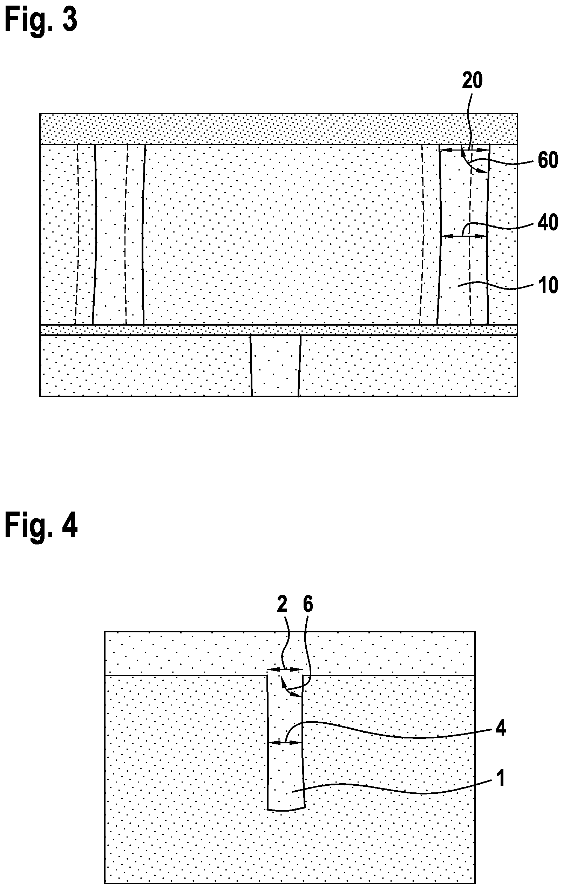

Fig. 1 shows a microscope image of a microsection of a TGV of a substrate according to an embodiment of the present invention and Fig. 2 shows a microscope image of an elastic mass removed from a TGV of the substrate of Fig. 1. Fig. 1 and also Fig. 3 show a plurality of same TGVs in the plane of projection and also behind one another perpendicular to the plane of projection, the latter shown in dashed lines.

In detail, Fig. 1 shows a microscopic image comprising a plurality of generally identical through-glass vias TGV 10, i.e. manufactured with the same manufacturing method. The TGV 10 is measured having the following properties:
- taper angle 60 at the top of about 85 degrees,
- taper angle 70 at the bottom of about 84,5 degrees,
- top diameter 20 of about 145 micrometers,
- bottom diameter 50 of about 111 micrometers,
- neck diameter 40 of about 76 micrometers, and
- length 30 of about 560 micrometers.

Fig. 2 now shows an elastic mass 1 in form of silicone, filled into the TGV 10, hardened and then removed from the TGV 10. The elastic mass 1 is also measured having the following properties:
- taper angle 6 at the top of about 87 degrees,
- taper angle 7 at the bottom of about 86 degrees,
- top diameter 2 of about 151 micrometers,
- bottom diameter 5 of about 110 micrometers,
- neck diameter 4 of about 79 micrometers, and
- length 3 of about 542 micrometers.

As can be observed through comparison of the measured properties of the TGV 10 and its "negative image" in form of the elastic mass 1, the properties are in good agreement with each other.

Fig. 3 shows a microscope image of a microsection of a TGV of a substrate according to an embodiment of the present invention and Fig. 4 shows a microscope image of an elastic mass removed from a TGV of the substrate of Fig. 3.

In detail, Fig. 3 shows a microscopic image comprising a plurality of the same through-glass via TGV 10. The TGV 10 is measured having the following properties:
- taper angle 60 at the top of about 89 degree,
- top diameter 20 of about 149 micrometers, and
- neck diameter 40 of about 138 micrometers.

These values have been obtained by measuring 10 TGV L1-L10:

| **Microsection VIA #** | **Diameter Top [µm]** | **Taper Angle Top [°]** | **Diameter neck [µm]** |
|---|---|---|---|
| L1 | 148,5 | 89,3 | 137,8 |
| L2 | 150,1 | 88,9 | 138,2 |
| L3 | 151,2 | 89,3 | 139,9 |
| L4 | 150,1 | 88,7 | 139,4 |
| L5 | 147,4 | 89,1 | 138,3 |
| L6 | 149,6 | 88,7 | 139,4 |
| L7 | 149,1 | 88,9 | 135,6 |
| L8 | 148,5 | 88,8 | 134,6 |
| L9 | 147,5 | 89,5 | 138,9 |
| L10 | 150,7 | 88,8 | 140,5 |
| | | | |
| **MEAN** | **149** | **89** | **138** |
| **StDev.** | **1** | **0** | **2** |

Fig. 4 now shows an elastic mass 1 in form of silicone, filled into the TGV 10, hardened and then removed from the TGV 10. The elastic mass 1 is also measured having the following properties:
- taper angle 60 at the top of about 89 degree,
- top diameter 20 of about 149 micrometers, and
- neck diameter 40 of about 141 micrometers.

These values have been obtained by measuring 18 elastic masses in form of silicone

| **Silicone stamp #** | **Diameter Top [µm]** | **Taper Angle Top [°]** | **Diameter neck [µm]** |
|---|---|---|---|
| S1 | 152 | 89,6 | 144 |
| S2 | 150 | 89,6 | 141 |
| S3 | 151 | 89,6 | 140 |
| S4 | 149 | 89,1 | 139 |
| S5 | 144 | 89,5 | 137 |
| S6 | 148 | 88,9 | 138 |
| S7 | 148 | 88,8 | 138 |
| S8 | 143 | 88,7 | 136 |
| S9 | 148 | 88,9 | 138 |
| S10 | 148 | 88,6 | 137 |
| S11 | 148 | 88,6 | 143 |
| S12 | 148 | 88,1 | 142 |
| S13 | 148 | 88,3 | 145 |
| S14 | 152 | 87,8 | 142 |
| S15 | 147 | 88,6 | 139 |
| S16 | 152 | 88 | 148 |
| S17 | 151 | 88,1 | 142 |
| S18 | 152 | 88,5 | 140 |
| | | | |
| **MEAN** | **149** | **89** | **141** |
| **StDev.** | **3** | **1** | **3** |

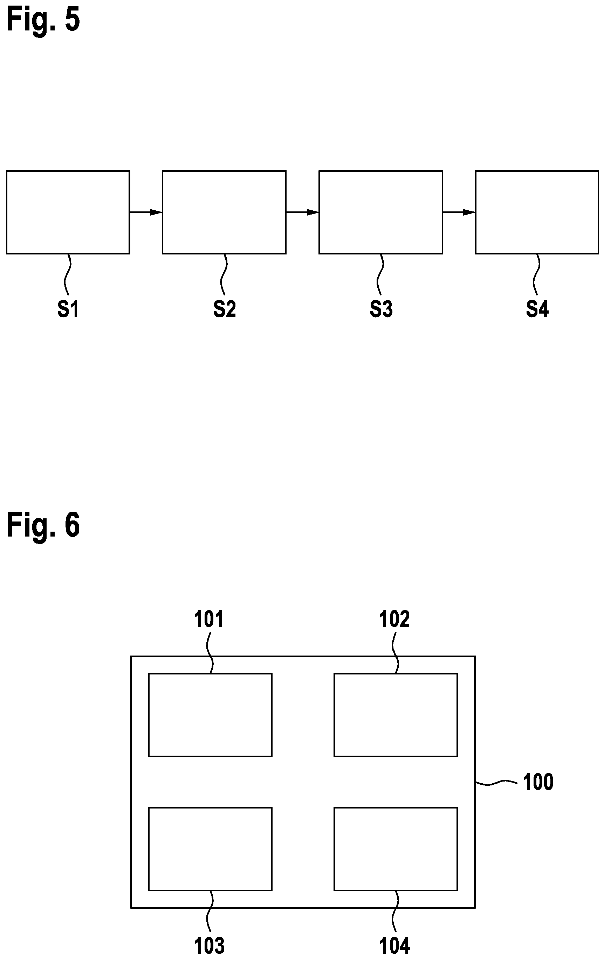

Fig. 5 shows steps of a method for non-destructive inspection of a structure, of a substrate according to an embodiment of the present invention.

In detail, Fig.5 shows steps of a method for non-destructive inspection of a structure, preferably a through-glass via, TGV, of a substrate, preferably a glass substrate.

The method comprises the steps of
- Applying S1 a mouldable mass onto a surface of said structure of said substrate,
- Hardening S2 of said mouldable mass such that the mass is elastic,
- Non-destructive removing S3 of said elastic mass from said structure, and
- Analyzing S4 said removed elastic mass according to at least one parameter, preferably a quality parameter.

Fig. 6 schematically shows a system for non-destructive inspection of a structure, of a substrate according to an embodiment of the present invention.

In detail, Fig. 6 schematically shows a system for non-destructive inspection of a structure, preferably a through-glass via, TGV, of a substrate, preferably a glass substrate. The system 100 comprises
an applying entity 101 adapted for applying a mouldable mass onto a surface of said structure of said substrate,
a hardening entity 102 adapted for hardening of said mouldable mass, such that the mass is elastic,
a removing entity 103 adapted for non-destructive removing of said elastic mass from said structure, and
an analyzing entity 104 adapted for analyzing said removed elastic mass according to at least one parameter, preferably a quality parameter.

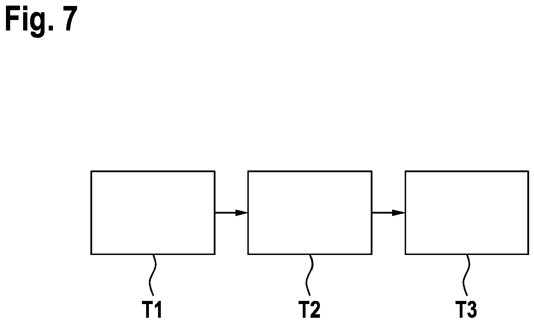

Fig. 7 shows steps of a method for manufacturing of a structure of a substrate according to an embodiment of the present invention.

In detail, Fig. 7 shows steps of a method for manufacturing a structure preferably a through-glass via, TGV, of a substrate, preferably a glass substrate.

The method comprises the steps of:
- Providing T1 a substrate,
- Forming T2 a structure in and/or on said substrate, and
- Inspecting T3 said structure by performing a method according to one of the claims 1-10.

In summary, the present invention may provide and/or enables the following features and/or advantages:
- Easy implementation.
- Precise measurement of properties of structures of substrates.
- Cost-effective manufacturing and further processing of substrates with structures.
- Easy handling and processing
- High flexibility in terms of quality parameters.
- High flexibility in terms of measuring methods for quality parameters.
- Non-destructive inspection of structures in and/or on substrates.

Many modifications and other embodiments of the invention set forth herein will come to mind to the one skilled in the art to which the invention pertains, having the benefit of the teachings presented in the foregoing description and the associated drawings. Therefore, it is to be understood that the invention is not to be limited to the specific embodiments disclosed and that modifications and other embodiments are intended to be included within the scope of the appended claims. Although specific terms are employed herein, they are used in a generic and descriptive sense only and not for purposes of limitation.

### List of reference signs

- 1: Elastic mass
- 2: Top diameter
- 3: Length
- 4: Neck diameter
- 5: Bottom diameter
- 6: Taper angle
- 7: Taper angle

- 10: TGV
- 20: Top diameter
- 30: Length
- 40: Neck diameter
- 50: Bottom diameter
- 60: Taper angle
- 70: Taper angle

- 100: System
- 101: Applying entity
- 102: Hardening entity
- 103: Removing entity
- 104: Analyzing entity

- S1-S4: Steps according to the method of the present invention
- T1-T3: Steps according to the method of the present invention

## Claims

1. Method for non-destructive inspection of a structure, preferably a through-glass via (10), TGV, of a substrate, preferably a glass substrate,
comprising the steps of
- Applying (S1) a mouldable mass onto a surface of said structure of said substrate,
- Hardening (S2) of said mouldable mass such that the mass is elastic,
- Non-destructive removing (S3) of said elastic mass from said structure, and
- Analyzing (S4) said removed elastic mass according to at least one parameter, preferably a quality parameter.

2. Method according to claim 1, wherein said hardening is performed by applying at least one of
- chemical hardening, preferably by additional chemical additives,
- electromagnetic radiation, preferably IR-radiation and/or UV-radiation,
- solidification and/or conglomeration from a solution by volatilization of a solvent, and
- cooling and/or heating.

3. Method according to one of the claims 1-2, wherein said hardening is performed within less than 1 hour, preferably less than 15 minutes, preferably less than 10 minutes, preferably less than 5 minutes.

4. Method according to one of the claims 1-3, wherein said elastic mass has a shore hardness below 70 A, preferably between 25 A and 65 A, preferably between 50 A and 60 A, after removal of said elastic mass from said surface.

5. Method according to one of the claims 1-4, wherein said structure of said substrate is provided in form of at least one of a groove, a cavity, a trench, a channel, an indentation, preferably in form of a scratch, a via, a blind hole, an edge, a rim or a pillar.

6. Method according to one of the claims 1-5, wherein said elastic mass is provided having a mould precision below 1 micrometer, preferably below 0.5 micrometer, preferably below 0.1 micrometer.

7. Method according to one of the claims 1-6, wherein said mouldable mass is provided in form of at least one of a thermoplastic, an elastomer, preferably silicone, rubber, resin, and/or epoxy, an adhesive.

8. Method according to one of the claims 1-7, wherein said at least one parameter represents a surface roughness of said structure and/or a geometry of said structure, preferably wherein said parameter representing geometry specifies at least one of surface area, volume, height, length, width, circularity, diameter, depression depth, taper angle, hour glass angle, waist size, perpendicularity and/or deviation from a theoretical structure.

9. Method according to claim 8, wherein said parameter representing geometry is determined using light microscopy and/or wherein said parameter representing surface roughness is determined using light interference spectroscopy.

10. Method according to one of the claims 1-9, wherein said at least one parameter is determined using light microscopy and/or interference spectroscopy, computer tomography, electron microscopy and/or fluorescence spectroscopy.

11. System (100) for non-destructive inspection of a structure, preferably a through-glass via (10), TGV, of a substrate, preferably a glass substrate, comprising
an applying entity (101) adapted for applying a mouldable mass onto a surface of said structure of said substrate,
a hardening entity (102) adapted for hardening of said mouldable mass, such that the mass is elastic,
a removing entity (103) adapted for non-destructive removing of said elastic mass from said structure, and
an analyzing entity (104) adapted for analyzing said removed elastic mass according to at least one parameter, preferably a quality parameter,
preferably wherein said analyzing entity (104) comprises at least one of a microscopy entity, preferably a light microscopy entity and/or an electron microscopy entity, a spectrometer entity, preferably an interference and/or fluorescence spectrometer entity, a tomography entity, preferably a computer tomography entity and/or a magnetic resonance imaging entity.

12. System (100) according to claim 11, wherein said system (100) further comprising at least one of
- a holding entity adapted for holding a substrate, said substrate comprising at least one structure,
- a feeder entity adapted to feed said substrate to at least one other entity,
- a supplying entity adapted to supply said mouldable mass to said applying entity,
- a display entity adapted to display at least one of
∘ a 2D and/or 3D image of said elastic mass,
∘ a result of said analysis, or
∘ a 2D and/or 3D image of said structure.

13. Method for manufacturing a structure preferably a through-glass via (10), TGV, of a substrate, preferably a glass substrate, comprising the steps of:
- Providing (T1) a substrate,
- Forming (T2) a structure in and/or on said substrate,
- Inspecting (T3) said structure by performing a method according to one of the claims 1-10.

14. Method according to claim 13, wherein prior to inspecting (T3) said structure and/or after removing of said elastic mass from said structure, said surface of said structure is cleaned by applying one or more cleaning procedures, preferably comprising at least one of one or more intense alkaline cleaners, one or more acidic cleaners, one or more neutral cleaners, one or more rinsing fluids, preferably carried out in one or more tempered ultrasonic and/or megasonic bathes,
preferably wherein prior to performing a cleaning procedure the surface to be cleaned is measured to obtain a pollution indication parameter of said surface and when said pollution indication parameter exceeds a threshold the cleaning procedure is performed.

15. Substrate, preferably a glass substrate, comprising a structure, preferably a through-glass via (10), TGV, provided by a method according to one of the claims 13-14.
